# EUROPEAN PATENT APPLICATION

(11) **EP 1 089 474 A2**
(43) Date of publication of application: **04.04.2001**
(21) Application number: 00402589.6
(22) Date of filing: 19.09.2000
(51) Int. Cl.: H04J 3/07, H03L 7/00

(54) **Desynchronizer circuit for time division frame tributaries in telecommunications networks and method thereof**

(30) Priority: 30.09.1999 IT TO990841
(71) Applicant: ALCATEL, 75008 Paris (FR)
(72) Inventor: Traverso, Giovanni, 23807 Rovagnate, Lecco (IT); Pais Golin, Orsola, 32041 Auronzo di Cadore, Belluno (IT); Razzetti, Luca, 20099 Sesto San Giovanni, Milano (IT)
(74) Representative: Colombo, Stefano Paolo

(57) **Abstract**

Desynchronizer circuit for time division frame tributaries in telecommunications networks, said circuit being able to perform a desynchronization of synchronized tributaries (TS) by means of a writing and reading operation in an elastic memory (14, 24), wherein the reading operation is controlled by a reading signal (CKR; FR) obtained through a locking and filtering process on writing signals (CKW, FW) operated through phase locking means (10, 20), said phase locking means (10, 20) performing a second order transfer function. According to the invention, said phase locking means (20) comprise digital integrator means (22) with variable parameters, able to assume different operation configurations upon reception of appropriate control signals (WB), said different operation configurations conferring different frequency behaviours (ω₁, ζ₁, ω₂, ζ₂) to the phase locking means (20).

## Description

The present invention relates to a desynchronizer circuit for time division frame tributaries in telecommunication networks which is able to perform a desynchronization of synchronized tributaries.

In order to transmit more signals simultaneously, such as several telephone signals, on the same transmission line, the present telecommunications networks can make use of two different techniques: one technique assignes a single transmission carrier for each signal, for example a pair of physical wires, and it is called space division technique. The second technique provides a multiplexing operation, i.e. associating several simultaneous signals on a single transmission carrier. Such an operation may be performed according to two distinct multiplexing techniques, i.e. a frequency division technique and a time division technique, so identified according to the domains where they operate.

From now on reference will be made to numerical multiplexing systems using time division techniques, in particular to synchronous systems, which have their largest application in SDH systems (Synchronized Digital Hierarchy).

In synchronous numerical multiplexing systems inside a network node, such as a switch matrix, all clock signals of the tributaries operate at the same instantaneous frequency, i.e. the frequency of a so called local oscillator associated to the node, which oscillator usually consists of a high stability atomic clock.

Tributaries entering the synchronized node are sent by other nodes or asynchronous transmitters, namely said transmitters are subject to synchrony requirements of the tributaries frequency, which are less strict than those associated to SDH systems. Therefore, said tributaries are defined plesiochronous, i.e. each of them has a frequency which is slightly different with respect to the reference frequency of the local oscillator; when they enter the node, they undergo a mapping operation performed with the aim of adapting said plesiochronous tributaries for their insertion in the synchronous frames used inside the node and operating at the frequency of the local oscillator.

This is obtained through operations essentially involving a first step of writing in an elastic memory through a clock signal derived from the input plesiochronous tributary, followed by a subsequent step of rereading the tributary contained in the elastic memory by means of a clock signal associated to the local oscillator. Information contents of the tributaries, previously plesiochronous and now synchronous, is entered in the switch matrix along with appropriate pointers indicating the relevant position, as well as with some bytes and bits used for packing such information contents and correct input frequency differences or mistuning. In SDH structures, for example, in the instance of a plesiochronous tributary mapping at 2,048 kbit/s in a Virtual Container VC-12, justification signalling bits c1 and c2 as well as corresponding justification opportunity bits s1 and s2, called negative or positive, respectively, are associated to the mapped tributary. If the corresponding signalling bit is placed on logic one, the justification opportunity bit s1 available may be used for writing, for example, one more information bit, which will be in excess with respect to the places available in a frame segment due to a slightly higher frequency associated to the input plesiochronous tributary. Vice-versa, if the input frequency is slightly lower than the frequency of the local oscillator, so that the available bits tend to leave some voids in the frame, these voids will be filled by the bit s1, which becomes a filling bit.

Once the tributaries have been elaborated in the node as required, such as relocating the packets of information contents comprised in the tributaries, said so handled tributaries should be entered again in the communication network leaving the synchronous environment consisting of the node and hierarchic structure associated to it, to become again plesiochronous tributaries.

Therefore, it is necessary to recover inside the node the information contents from the synchronized tributaries forming the plesiochronous tributary to be then inserted in the network, for instance at a frequency of 2,048 Kbit/s. For defining such a recovery function, reference is made e.g. to Standard *ETS-300 417 4.1, June 1997, pp. 228-240.*

Information recovery procedure from the synchronized tributaries is performed by means of an analogous but inverse procedure with respect to the mapping procedure, namely a demapping procedure.

Substantially, according to the demapping procedure, after a demultiplexer circuit has in fact demultiplexed the tributaries of the time division frame, each tributary, still synchronized with the local oscillator, is written in an elastic memory under control of a writing operation associated to the frequency of the tributary itself at the input of the elastic memory.

Said tributary is then read again through a reading clock signal generated by a phase locked loop receiving the write operation at the input as the frequency to be followed. The reading clock signal must be a "smoothed" signal, namely a signal, whose phase deviations contained in the writing operation due to various irregularities determined by the control and filling byte and bits are dampened through an integration procedure. To this purpose, filtering with a very narrow band is also required due to the high frequency of said irregularities.

The use of a first-order phase locked loop, though representing as such a low-pass filter, is not advisable, since it has a static deviation on the phase, which is inversely proportional to the band width.

For this reason, therefore, the phase locked loop being used forms, when the loop is closed, a second order system, wherein said static deviation is free from the band, more precisely it is null.

As said above, the phase locked loop provides a low-pass filtering for producing the read clock signal. The read clock signal so obtained should have for example a 2048 KHz ± 50 ppm (parts per million) frequency.

The circuit performing this function, substantially consisting of the phase locked loop and elastic memory, is called a desynchronizer circuit and substantially represents the last circuit elaborates the tributaries before entering the transmission lines.

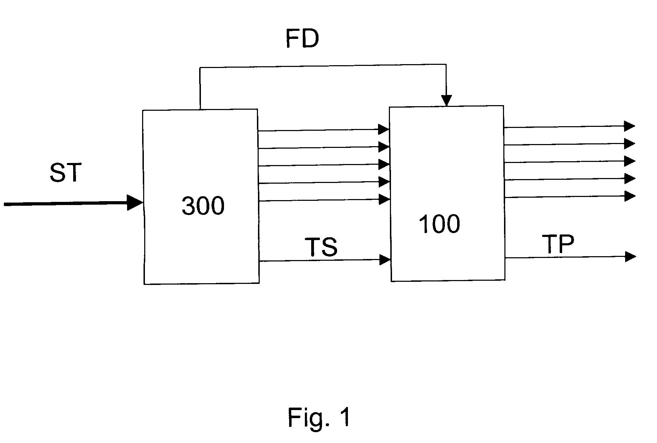

Figure 1 represents a block diagram of the demapping procedure, where a frame ST, namely an SDH frame, is sent to the input of a demultiplexer circuit 300, which outputs a plurality of synchronous tributaries TS still having the node synchronism supplied by the local oscillator and still containing a few control bytes, in particular justification and redundancy bytes. In the example of a Virtual Container VC-12, the synchronous tributaries TS exiting the demultiplexer circuit 300 are in number of 63 at a frequency of 2,048 Kbit/s. A signal with a demultiplexing frequency FD is also picked up from the demultiplexer circuit 300, which signal is a clock signal with some voids, i.e. the so called "holes" or "piercings" in the time positions corresponding to the bytes not being part of the information contents. It should be noticed that in final implementation the signal with multiplexing frequency FD, alike most pierced clock signals, corresponds to a non pierced clock signal being sent to each device along with a signal generated by the logic controlling the time division frame and taking information relating to the clock signal instants to be considered as pierced.

Said signal with demultiplexing frequency FD is used for driving a desynchronizer circuit 100, which receives synchronous tributaries TS at the input and will output plesiochronous tributaries TP, each of them being locked to its proper plesiochronous frequency generated in the desynchronizer circuit 100.

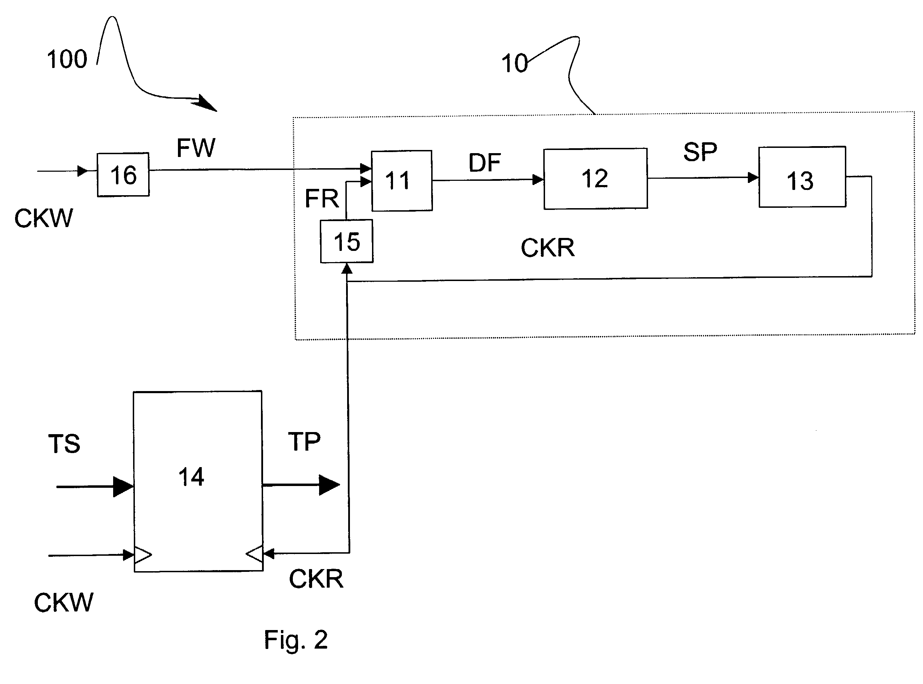

Figure 2 is representing a basic block diagram of the desynchronizer circuit 100 associated to a general synchronous tributary TS downstream the demultiplexer circuit 300, according to the known state of the art.

This figure shows a phase locked loop 10, which is obtained through a phase comparator 11 receiving at its input a writing phase FW obtained from a writing clock signal CKW through a time base circuit 16. The writing clock signal CKW substantially has the frequency of the local oscillator and is derived from the signal with demultiplexing frequency FD. The phase comparator 11 also receives at its input a reading phase FR scanning the reading address obtained from a reading clock signal CKR through a time base circuit 15, and will output a phase error DF. Also in this case, frequency will always be referred to in the following as measured quantity, however, the phase comparator 11 carries out a measurement of the phase deviation, which can be easily associated to a frequency deviation.

The frequency error DF is then sent to an integrator filter 12 performing a determined transfer function, and will output a driving signal SP for driving a controlled digital oscillator 13, which outputs in its turn the reading clock signal CKR, wherefrom read phase FR that is fed back to the phase comparator 11 is obtained.

The synchronous tributary TS is sent to an elastic memory 14, whose writing operations are scanned by the writing clock signal CKW and controlled by the writing operation FW. Said writing operation FW is generated by the time base 16, taking also into consideration the effect of the justification bits associated to the synchronous tributary TS.

Therefore, from the elastic memory 14 plesiochronous tributaries TP are read out according to the reading clock signal CKR and the associated reading phase FR.

Therefore, more bits or less bits have to be written in the elastic memory 14 under control of the time base circuit 16 due to the above described justification technique, i.e. in the event of a frequency mistuning the input plesiochronous tributary is adapted inside the frame by means of justification bits available for compensating said frequency differences.

The time base circuit 16 generating the writing phase also considers these more bits or less bits for generating the writing phase FW, since they determine a shift of the information contents inside the frame, and performs write operations to that purpose using the deactivation times of the elastic memory 14.

As a main consequence, such writing operations will determine for the writing phase FW an average frequency differing from the frequency of the writing clock signal CKW. For this reason, the phase locked loop 10 is locked to the write phase FW, so as to avoid a possible overflow or underflow of the elastic memory 14.

Therefore the desynchronizer circuit operates a new packing of the information contents forming the outputted plesiochronous tributaries TP, making up for the adaptations originally introduced through the justification bits at the input time of the plesiochronous tributary in the node, and will reread said tributary through a reading clock signal CKR and a reading phase FR locked to the writing phase FW, but properly smoothing, through the integrator filter 12, the irregularities of said read phase FR due to justification and redundancy operations.

The phase locked loop 10, as said above, implementes a second order filter, which removes the static error on the reading clock signal CKR.

However, there are some drawbacks. The phase locked loop 10, as a second order system, has a very long time constant for frequency locking due to the band narrowness, and a much shorter time constant for phase locking. As a result, the phase locked loop 10 operates correctly as long as it does not loose its frequency locking.

In particular, should a mistuning between the writing phase FW and reading phase FR at the input of the phase comparator 11 reach too high values and exceed the maximum input value that the phase comparator 11 is able to handle, i.e. mistuning is such to cause overflow in the counter representing the phase comparator 11, a second phenomenon will be added to the intrinsic slowness of the phase locked loop in following the input frequency, due to the loss of the frequency locking, said second phenomenon being such that by virtue of an overflow the frequency error DF may start a rough uncontrolled oscillation from very high values to very low values. Even if not clearly detailed in figure 1, the phase comparator 11 may be regarded as consisting of two writing and reading comparators, respectively, whose output is sent to an adder. When the maximum value is exceeded, the adder executing the difference between both writing and reading counters of the phase comparator 11 starts counting from zero again, so that the frequency error value DF will suddenly go down and generate oscillations to the phase locked loop 10.

Therefore, since the loop band width has to be a narrow one so as to smooth high frequency jitter phenomena and pointer movements, which are the main objectives of the desynchronizer circuit, a desynchronizer circuit of this type has the drawback that a big input frequency shift of said circuit will raise a long transient caused by the rising of oscillating phenomena in the phase locked loops combined with a long time constant for the frequency locking. In other words, the need of a narrow band causes a slowness of the phase locked loop in following frequency shifts, so that the phase locked loop is not able to quickly remove the drawback and has also to undergo the impact of the oscillations caused by the overflow phenomenon, which introduce an uncertainty element on the direction to be taken for convergence recovery. The transients so originated may even last minutes, during which output data will be lost, i.e. the communication is silenced.

A solution increasing the size of the phase comparator would not be convenient, since such an increase should be highly consistent and, in princile, an undefined one. Moreover, the size of the phase comparator is strictly tied to the size of the elastic memory, since both devices must be capable of absorbing the same frequency differences for ensuring good operation of the desynchronizer circuit; therefore, also the memory size would have to be increased, involving unacceptable costs.

Moreover, another drawback similar to the one described above is also caused by events of Signal Server Fail, i.e. where the input line to the node for example is interrupted and an AIS (Alarm Indication Signal), representative of the silenced line, is received. Such an AIS signal consists of a sequence of logic "ones" propagating in the node instead of the data signal, in order to notify the failure. When the AIS signal reaches the desynchronizer circuit, it will cause malfunctionings in the elastic memory management. In fact, the logic "ones" of the AIS signal are interpreted as the contents of the justification signalling bits c1 and c2, thus continuously and erroneously requiring the desynchronizer circuit to write more bits in the elastic memory. This determines a fast increase of the frequency associated to the writing phase and an equally fast loss of frequency locking for the phase locked loop with a consequent overflow of the phase comparator. When the AIS signal is suppressed at the end of the failure, several minutes of valid data are lost before locking is recovered again.

It is the object of the present invention to solve the above drawbacks and provide a desynchronizer circuit for time division frame tributaries in telecommunication networks, having a more efficient and improved performance compared to the existing solutions.

In this scenario, it is the main object of the present invention to provide a desynchronizer circuit for time division frame tributaries in telecommunication networks, which substantially reduces transients duration of the desynchronizer circuit due to input mistunings.

A further object of the present invention is to provide a desynchronizer circuit for time division frame tributaries in telecommunication networks, capable of managing alarm events, in particular the ones generated by line interruption situations.

A further object of the present invention is to provide a desynchronizer circuit for time division frame tributaries in telecommunication networks, whose manufacture involves reasonable costs and a reasonable space for the circuit.

In order to achieve such objects, the present invention provides a desynchronizer circuit for time division frame tributaries in telecommunication networks, and/or a desynchronizer method for time division frame tributaries in telecommunication networks, incorporating the features of the annexed claims, which form an integral part of the description herein.

Further objects, features and advantages of the present invention will become apparent from the following detailed description and annexed drawings, which are supplied by way of non limiting example, wherein:
- Fig. 1 shows a block diagram of a demapping procedure according to the known state of the art;
- Fig. 2 shows a basic schematic diagram of a circuit implementing a desynchronizer circuit for time division frame tributaries in telecommunication networks, according to the known state of the art;
- Fig. 3 shows a basic schematic diagram of a circuit implementing a desynchronizer circuit for time division frame tributaries in telecommunication networks, according to the present invention; and
- Fig. 4 shows a diagram of a detail of the circuit implementing a desynchronizer circuit for time division frame tributaries in telecommunication networks, as represented in Fig. 3.

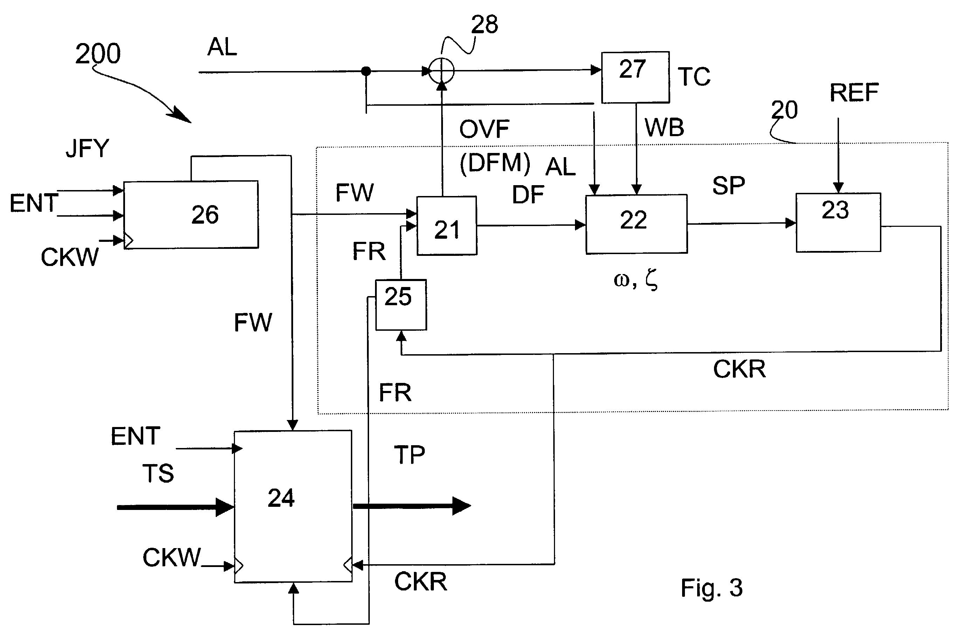

Figure 3 shows a basic schematic diagram of a circuit implementing a desynchronizer circuit for time division frame tributaries in telecommunication networks according to the present invention.

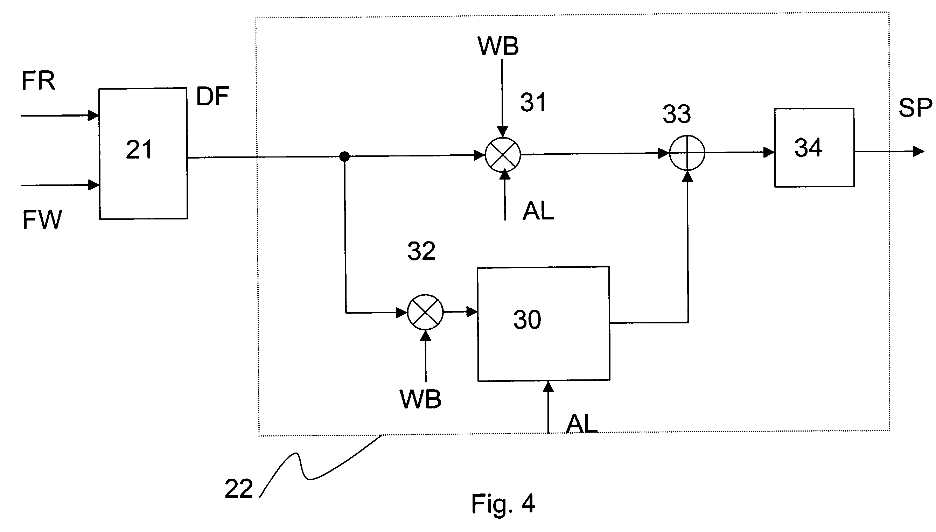

The tributary desynchronizer circuit 200 comprises first of all a phase locked loop 20, which comprises in its turn a phase comparator 21, which receives at its input a writing phase FW and a reading phase FR and outputs a frequency error DF proportional to their frequency difference. The phase comparator 21 is also apt to send an overflow signal OVF when the frequency difference at its input exceeds a maximum frequency difference DFM. The frequency error DF is sent to an integrator filter 22. Said integrator filter 22 has a transfer function, whose parameters are variable. In particular, the integrator filter 22 is a digital filter with sigma-delta conversion, as shown more in detail in figure 4. For simplicity's sake, reference will be made in the following to natural frequency ωₙ and damping factor ζ, as variable parameters proper of the second order system associated to the closed loop transfer function of the phase locked loop 20, rather than to the transfer function parameters of the integrator filter 22, as they are the ones undergoing a real change.

The integrator filter 22 supplies a driving signal SP to a controlled digital oscillator 23, which is substantially obtained through a dividing circuit which, in the example of a 2,048 Kbit/s tributary, divides a reference signal REF at a frequency of 51 MHz by 25 or 26. The reading clock signal CKR obtained by the controlled digital oscillator 23 is sent on the feedback loop to the phase comparator 21. However, a read counter 25 is interposed on the feedback loop for driving an elastic memory 24 and will send the reading phase FR, locked to the reading clock signal CKR, to said elastic memory 24. As already mentioned, the reading phase FR is also supplied to the phase comparator 21 of the phase locked loop 20. Similarly, a writing counter 26 is provided, which receives at its input a justification signal JFY, a tributary enable signal ENT and the writing clock signal CKW, which is also supplied to the elastic memory 24. The justification signal JFY is used by the writing counter 26 for taking into account the justification bits entered during the mapping operation, whereas the tributary enable signal ENT activates the writing counter 26 for operation only upon arrival of the relevant synchronized tributary TS. The tributary enable signal ENT is also sent to the elastic memory 24 with the same function. According to said signals, the writing counter 26 drives, according to the appropriate writing phase FW, the writing operations of the synchronous tributary TS in the elastic memory 24, locked to writing clock signal CKW, which as said above is obtained from the demultiplexing frequency signal FD of the tributaries associated to the demultiplexer circuit 300 of figure 1 and is located upstream the desynchronizer circuit 200. As already seen with reference to figure 2, the writing phase FW has a different average frequency, since upon request of the justification signal JFY, the writing counter 26 enables a writing operation in the elastic memory 24, in order to write one more bit because of the justification function during the mapping operation. This writing operation is performed while the enable signal of the tributary ENT is off, using the time division structure of the frames to write in the memory 24 within a time during which both the writing counter 26 and the memory 24 would normally be deactivated, whereas for absorbing certain bits are not written during the activation time.

As mentioned above, the writing phase FW is also sent to the phase comparator 21 for comparing it with the reading phase FR.

Clearly, the reading clock signal CKR for the reading operations of the plesiochronous tributary TP is picked up by the phase locked loop 20, upstream the read counter 25.

The operation of the desynchronizer circuit according to the present invention is as follows.

When a too high frequency difference occurs, exceeding the maximum frequency difference DFM between the writing clock signal CKW and the reading clock signal CKR, and consequently in the accordingly scanned writing phase FW and reading phase FR, the phase comparator 21 emits an overflow signal OVF, which is received by a timing circuit 27. Substantially said timing circuit 27 consists of a timer, which is activated following reception of the overflow signal OVF for a preset time, called maximum convergence time TC, lasting for example one second. Said maximum convergence time TC is the time during which it is desired to have the phase locked loop 20 going back to its standard operation. During this preset time, the timing circuit 27 sends a wideband signal WB to the integrator filter 22. The integrator filter 22, in its normal operating status, operates in order to obtain a first natural frequency ω₁ and a first damping factor ζ₁ for the phase locked loop 20, which are suitable for narrow-band filtering. However, the integrator filter 22 has variable parameters, i.e. as better described in figure 4, is capable of changing its parameters upon reception of the wideband signal WB and originating a second natural frequency ω₂ and a second damping factor ζ₂, whose values are calculated as a function of the maximum frequency difference DFM, such as 50 ppm, which is acceptable at the input of the phase comparator 21, and of the maximum convergence time TC, such as one second. Thus, a too wide frequency swing, exceeding the preset maximum frequency difference DFM, determines such a band widening of the phase locked loop 20, so that within a preset time, i.e. the maximum convergence time TC, the phase locked loop 20 may be able to relock itself to the writing phase FW and avoid oscillations, whose duration would be undetermined due to its extreme slowness.

Once the maximum convergence time TC has passed, if in the meanwhile the frequency difference has returned below the maximum frequency difference DFM and the overflow signal OVF is off, the integrator filter 22 will go back to the parameters configuration determining the first natural frequency ω₁ and first damping factor ζ₁ for the phase locked loop 20, i.e. back to its usual narrow-band transfer function.

Figure 3 is also showing how the overflow signal OVF is sent to a mixer 28 before reaching the timing circuit 27, which also receives an alarm signal AL representing a Server Signal Fail status (SSF), i.e. a signal not received in the node, which may derive for example from a failure on the input line. In this event, the input signal, as described above, is an AIS signal, i.e. a sequence of logic ones.

In the event of an alarm signal AL, said signal will preset through the mixer 28 the timing circuit 27 to send the wideband signal WB. This action is undertaken to put anyway the timing circuit 27 in a known condition when the alarm situation expressed by the signal AL will cease. In fact, the timing circuit 27 is also operated by the overflow signal OVF emitted by the phase comparator 21. Moreover, the alarm signal AL operates the integrator filter 22, as better described with reference to figure 4, causing open loop operation of the phase locked loop 20. Thus, the output frequency of the phase locked loop 20 is the free frequency of the controlled oscillator 23, usually a suitable frequency also for SDH frames, which determines a small mistuning when the alarm signal AL goes off compared to the one generated by a closed loop operation, which on the contrary may even reach thousands of ppm. When the alarm signal AL goes off, the phase locked loop 20 operates again as a closed loop, while the wide band signal WB under control of the overflow signal OVF will remain further emitted from the timing circuit 27 for the convergence time TC, so as to favour the quickest relocking.

The alarm signal AL is used instead of the overflow signal OVF for controlling the recovery of an integrator 30 represented in figure 4, in view of the fact that an overflow signal OVF can be caused also by a large phase shift, that however causes no mistuning. As a consequence, it would be a problem if the loop should open itself, the frequency locking going lost.

As to the desynchronizer circuit 200, it should be appreciated that even being referred to a general synchronous tributary TS, as already mentioned with reference to the figure 1, at the input there is a plurality of synchronous tributaries TS, for example 63 in the instance of a VC-12, so that the desynchronizer circuit elements 200 of figure 3 are in number of one for each synchronous tributary TS they refer to. On the contrary, what is common to all synchronized tributaries TS and peculiar to the time division systems is the control logic, not represented, which supplies the time division control, for example through the signals ENT and JFY, and also controls each memory 24, each timing circuit 27 and each integrator filter 22.

Figure 4 is a more detailed representation of the integrator filter 22. The integrator filter 22 receiving the frequency error DF is obtained in its known form as a proportional-integral control, with a proportional path going through a multiplier 31 to reach a mixer 33 and an integral path going through a multiplier 32 and the integrator 30 already mentioned, reaching a mixer 33. Downstream the mixer 33 a sigma-delta converter 34 will convert the output value represented by n bits of the mixer 33 in the binary serial sequence forming the driving signal SP for the controlled oscillator 24.

The multiplier 31 is operated by the wide band signal WB, and applies a multiplying factor on the proportional path, which is worth e.g. 64.

The multiplier 32 is also operated by the wide band signal WB, and applies a multiplying factor on the integral path, which is worth e.g. 8192, to increase the gain of the integrator 30. The integrator 30 is obtained through a simple summing circuit.

In stand-by conditions both multipliers 31 and 32 are deactivated, so that the frequency deviation DF with its integrated value is added to the mixer 33, and the integrator filter 22 will give the first natural frequency ω₁ and first damping factor ζ₁ to the phase locked loop 20.

When the frequency error DF determines an overflow signal OVF and consequently the transmission of the subsequent wide band signal WB activating multipliers 31 and 32, both the second natural frequency ω₂ and second damping factor ζ₂ are conferred to the phase locked loop 20. Activation of the multiplier 31 determines an enlargement of the frequency error on the proportional path, so that the controlled oscillator 24 is forced to change its value fast in an attempt of reducing this huge frequency error.

When the frequency error DF goes back below the overflow values and therefore the phase locked loop 20 is able to accomplish its frequency locking, even if somewhat slowly, also the contribution of the integral path where the multiplier 32 has increased the gain value of the integrator 30 becomes however appreciable and the frequency locking will be extremely faster.

At the expiration of the convergence time TC, multipliers 31 and 32, that are shifter circuits, are deactivated again and the integrator filter 22 will confer again the first natural frequency ω₁ and first damping factor ζ₁ to the phase locked loop 20.

Finally, the integrator 30 receives the alarm signal AL operating its recovery or reset, so as to cancel the contribution of the integral path in the event of a malfunction and determine the open loop operation of the phase locked loop 20. The signal AL also resets the contribution of the proportional path.

According to the above description the features of the present invention are clear and also its advantages are clear.

The desynchronizer circuit for time division frame tributaries in telecommunication networks according to the present invention will advantageously reduce the length of the transients raised by overflow on the phase comparator without changing the size of the latter. In fact, second parameters for the integrator are advantageously chosen based on a maximum acceptable duration of said transients and a maximum mistuning or frequency difference to be recovered, which parameters cause a widening of the closed loop band and consequent speed-up of the phase locked loop in following the input phase, when an excessive frequency difference causes a malfunction signalled by the phase comparator by means of the overflow signal.

This is advantageously obtained introducing a time circuit controlling the change of the integrator filter with variable parameters for the time required.

A further advantage is that only one time circuit needs to be added for each desynchronizer circuit, independently on the number of tributaries handled by the desynchronizer circuit.

A further advantage is that the desynchronizer circuit according to the present invention can manage also other malfunctions, such as Signal Server Fail signals.

It is obvious that many changes are possible for the man skilled in the art to the desynchronizer circuit for time division frame tributaries in telecommunications networks and/or desynchronizer method of time division frame tributaries in telecommunications networks described above by way of example, without departing from the novelty spirit of the innovative idea, and it is also clear that in practical actuation of the invention the components may often differ in form and size from the ones described and be replaced with technical equivalent elements.

Several sets of values can be used for the loop parameters depending on the entity of the drawbacks taking place, as well as different convergence curves.

## Claims

1. Circuit for desynchronizing time division frame tributaries in telecommunications networks, said circuit being able to perform a desynchronization of synchronous tributaries (TS) by means of writing and reading operations in an elastic memory (14, 24), the reading operation being controlled by a reading signal (CKR; FR) which is obtained through a locking and filtering process being carried out on writing signals (CKW, FW), the process being operated through phase locking means (10, 20), said phase locking means (10, 20) performing a second order transfer function, characterized in that said phase locking means (20) comprise digital integrator means (22) with variable parameters, able to assume different operation configurations upon reception of appropriate control signals (WB), said different operation configurations giving different frequency behaviours (ω₁, ζ₁, ω₂, ζ₂) to the phase locking means (20).

2. Circuit according to claim 1, characterized in that time activation means (27) are provided for controlling the transfer of said control signals (WB) to the integrator means (22).

3. Circuit according to claim 2, characterized in that the different frequency behaviours (ω₁, ζ₁, ω₂, ζ₂) and the parameter configurations of the integrator means (22) determining them are calculated as a function of a maximum deviation (DFM) associated to the frequency of one writing signal (CKW, FW) and as a function of a determined time interval (TC) within which convergence is desired.

4. Circuit according to claim 3, characterized in that the time activation means (27) send control signals (WB) for a time corresponding to the determined time interval (TC).

5. Circuit according to claim 4, characterized in that said time activation means (27) are triggered in their turn by a malfunction signal (OVF, AL).

6. Circuit according to claim 5, characterized in that said malfunction signal (OVF, AL) is an overflow signal (OVF) emitted by a phase comparator (21) belonging to the phase locking means (200).

7. Circuit according to claim 5, characterized in that said malfunction signal (OVF, AL) is an alarm signal (AL), in particular related to a Signal Server Fail status.

8. Circuit according to claim 7, characterized in that said alarm signal (AL) is also sent to the integrator means (22), which are able to determine an open loop operation of the phase locking means (200).

9. Circuit according to claim 1, characterized in that said integrator means (22) are obtained through a proportional-integral filter operating on a frequency difference signal (DF) generated by the phase comparator (21).

10. Circuit according to claim 9, characterized in that said digital integrator means (22) comprise multiplier means (31, 32) of the frequency difference signal (DF) on the proportional path and/or on the integral path.

11. Circuit according to claim 10, characterized in that said multiplier means (31, 32) are controlled by the control signal (WB) of the integrator means (22).

12. Circuit according to any of the previous claims, characterized in that said telecommunication networks operate according to SDH protocol.

13. Method for desynchronizing time division frame tributaries in telecommunications networks, said networks being able to receive synchronous tributaries (TS) and submit them to a resynchronization process through a writing and reading operation in an elastic memory (14, 24) according to a reading clock signal (CKR, FR) obtained from a writing phase (FW) associated to the synchronized tributary (TS) through a frequency locking operation and filtering with a second order filter (10, 20), characterized in that the step of filtering is carried out with variable frequency parameters of the second order filter (20), the variable frequency parameters depending on the frequency difference between the writing phase (FW) and the reading clock signal (CKR, FR).

14. Method according to claim 13, characterized by the step of calculating the frequency parameters of said second order filter (10) according to a maximum acceptable frequency difference (DFM) and desired convergence time (TC).

15. Method according to claim 14, characterized by the step of changing the frequency parameters of the second order filter (20) for a limited time substantially equal to convergence time (TC).

16. Method according to claim 15, characterized by the step of controlling the frequency parameter change of the second order filter (20) when the frequency difference between the writing clock signal (CKW; FW) and the reading clock signal (CKR, FR) exceeds a maximum value (DFM).

17. Method according to claim 15, characterized by the step of controlling the frequency parameter change of the second order filter (20) when an alarm signal (AL), in particular a signal indicating line interruptions, is received.

18. Method according to claim 17, characterized by controlling the frequency parameter change of the second order filter (20) by imposing an open loop operation of said second order filter (20).

19. Method according to claim 13, characterized in that the second order filter (20) is obtained by introducing a proportional integral filter (22) and in that the contribution of the proportional path and/or integral path is changed by means of multiplying operations whenever the frequency parameters of the second order filter (20) need to be changed.

20. Method according to any of the previous claims, characterized in that said telecommunication networks are SDH networks.
